Europäisches Patentamt

European Patent Office

Office européen des brevets

(19)

(11) Veröffentlichungsnummer: **0 120 457**
**A2**

(12) # EUROPÄISCHE PATENTANMELDUNG

(21) Anmeldenummer: **84103112.3**

(22) Anmeldetag: **21.03.84**

(51) Int. Cl.³: **H 01 L 31/16**
**H 04 B 9/00**

(30) Priorität: **25.03.83 DE 3311038**

(43) Veröffentlichungstag der Anmeldung:
**03.10.84 Patentblatt 84/40**

(84) Benannte Vertragsstaaten:
**DE FR IT**

(71) Anmelder: **kabelmetal electro Gesellschaft mit
beschränkter Haftung
Kabelkamp 20 Postfach 260
D-3000 Hannover 1(DE)**

(71) Anmelder: **Siemens Aktiengesellschaft
Berlin und München Wittelsbacherplatz 2
D-8000 München 2(DE)**

(72) Erfinder: **Baum, Walter, Dipl.-Phys.
Wedemeyerstrasse 9
D-3000 Hannover 1(DE)**

(72) Erfinder: **Cuno, Hans Hellmuth, Dr. Dipl.-Phys.
Birkenstrasse 11
D-8411 Laaber(DE)**

(72) Erfinder: **Hatzinger, Günther, Dipl.-Ing.
Wagnerweg 8
D-8124 Oberhaching(DE)**

(72) Erfinder: **Späth, Werner, Dipl.-Phys.
Burgstallerstrasse 10
D-8150 Holzkirchen(DE)**

(74) Vertreter: **Mehl, Ernst, Dipl.-Ing. et al,
Postfach 22 01 76
D-8000 München 22(DE)**

(54) **Optische Sender- und Empfängervorrichtung.**

(57) Die Erfindung betrifft eine optische Sender- und Empfängervorrichtung, bei der als Lichtsender eine Leuchtdiode (15) in eine Öffnung (12) eines Lichtempfänger (13) eingesetzt ist, für den eine Fotodiode oder ein Fototransistor verwendet wird. In dieser Öffnung (12) endet eine Lichtfaserleitung (1) für bidirektionalen Datenaustausch. In der Sendephase der Leuchtdiode (15) arbeitet der Lichtempfänger (13) als Monitor, während bei Lichtaustritt aus dem Ende (2) der Lichtfaserleitung (1) die Leuchtdiode (15) kein Licht abgibt und lediglich der Lichtempfänger (13) in Empfangsbetrieb ist.

FIG 3

EP 0 120 457 A2

Croydon Printing Company Ltd.

kabelmetal electro GmbH
Hannover

SIEMENS AKTIENGESELLSCHAFT

Unser Zeichen

Berlin und München

VPA 83 P 8007 E

## Optische Sender- und Empfängervorrichtung

Die Erfindung betrifft eine optische Sender- und Empfängervorrichtung mit einem Lichtsender und einem Lichtempfänger, mit einer an den Lichtsender und den Lichtempfänger fest angekoppelten Lichtfaserleitung zur Übertragung optischer Signale und mit einer Steuereinrichtung, die den Betrieb des Lichtsenders steuert.

Für zahlreiche einfache Anwendungen ist eine bidirektionale Datenübertragung über eine einzige Lichtfaserleitung, an die Lichtsender und Lichtempfänger direkt angekoppelt sind, ausreichend, um so Daten in beiden Richtungen übertragen zu könnnen. Unter Licht ist dabei wie im folgenden elektromagnetische Strahlung zu verstehen, deren Wellenlänge auch außerhalb des sichtbaren Bereichs liegen kann.

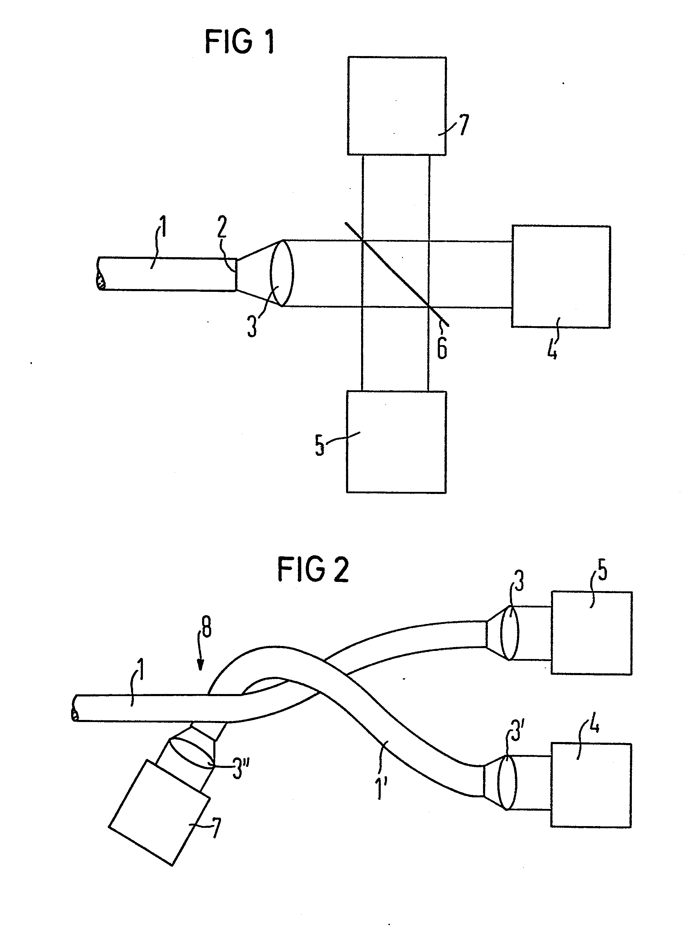

Die Fig. 1 und 2 zeigen verschiedene Möglichkeiten, mit denen ein bidirektionaler serieller Datenaustausch verwirklicht werden kann.

In Fig. 1 ist eine Lichtfaserleitung 1 gezeigt, die ein Ende 2 aufweist, aus dem Licht austritt bzw. in das Licht eingestrahlt wird. Eine Linse 3 fokussiert das von einem Lichtsender 5 ausgesandte und an einem halbdurchlässigen Spiegel 6 reflektierte Licht auf das Ende 2 der Lichtfaserleitung 1. Das aus diesem Ende 2 der Lichtfaserleitung 1 austretende Licht wird dagegen durch die Linse 3 parallel gerichtet und durch den halbdurchlässigen Spiegel 6 Kot 1 Dx / 24.03.1983

hindurch auf einen Lichtempfänger 4 geworfen. Der nicht am halbdurchlässigen Spiegel 6 reflektierte Anteil des vom Lichtsender 5 ausgesandten Lichtes gelangt durch den Spiegel 6 hindurch zu einem Monitor 7.

Der Lichtempfänger 4, der Lichtsender 5 und der Monitor 7 sind mit einer Steuereinrichtung verbunden, die deren Betrieb so einstellt, daß der Lichtsender 5 kein Licht abgibt, wenn der Lichtempfänger 4 gerade auf Empfang geschaltet ist. Sendet dagegen der Lichtsender 5 Licht aus, dann ist der Lichtempfänger 4 abgeschaltet, während der Monitor 7 dazu dient, den Betrieb des Lichtsenders 5 zu überwachen und ihn diesem auftretende Störungen gegebenenfalls zu melden.

Wenn an dem dem Ende 2 gegenüberliegenden Ende der Lichtfaserleitung 1 eine entsprechende Anordnung vorgesehen wird, dann ist es möglich, zwischen diesen Anordnungen Daten bidirektional über die Lichtfaserleitung 1 zu übertragen.

Fig. 2 zeigt eine ähnliche optische Sender- und Empfängervorrichtung, bei der einander entsprechende Bauteile mit dem gleichen Bezugszeichen wie in Fig. 1 versehen sind. Anstelle des halbdurchlässigen Spiegels 6 wird beim Beispiel von Fig. 1 aber eine zusätzliche kurze Lichtfaserleitung 1' verwendet, die an einer Koppelstelle 8 mit der zum Lichtsender 5 führenden Lichtfaserleitung 1 verspleißt ist und an ihrem der Koppelstelle 8 entgegengesetzten Ende zum Lichtempfänger 4 führt. Das an der Koppelstelle 8 liegende Ende der zusätzlichen Lichtfaserleitung 1' ist auf den Monitor 7 gerichtet.

Bei der in Fig. 2 dargestellten Sender- und Empfängervorrichtung ist zwar kein halbdurchlässiger Spiegel 6 erforderlich; dafür werden aber vor dem Lichtempfänger 4 und dem Monitor 7 zusätzliche Linsen 3' und 3'' benötigt. Außerdem ist die zusätzliche Lichtfaserleitung 1' erforderlich, die auch noch mit der Lichtfaserleitung 1 verspleißt werden muß.

Den in Fig. 1 und 2 gezeigten Sender- und Empfängervorrichtungen ist gemeinsam, daß sie für Lichtsender, Lichtempfänger und Monitor drei getrennte Bauelemente und überdies auch noch Zusatzeinrichtungen, wie beispielsweise den halbdurchlässigen Spiegel oder mehrere Linsen, benötigen. Zwar können Lichtsender, Lichtempfänger und Monitor auf Halbleiterbasis aufgebaut werden; dennoch bleibt der Gesamtaufwand nicht zuletzt wegen der Zusatzeinrichtungen beträchtlich.

Es ist daher Aufgabe der Erfindung, eine optische Sender- und Empfängervorrichtung anzugeben, die einen bidirektionalen Datenaustausch mit möglichst wenigen Bauelementen und Zusatzeinrichtungen erlaubt.

Diese Aufgabe wird erfindungsgemäß dadurch gelöst, daß der Lichtsender und der Lichtempfänger direkt an das gleiche Ende der Lichtfaserleitung angekoppelt sind und die Steuereinrichtung den Lichtempfänger so steuert, daß dieser wechselseitig mit dem Lichtsender arbeitet und auch als Monitor für den Lichtsender betreibbar ist.

In bevorzugter Weise ist der als Leuchtdiode gestaltete Lichtsender in eine Öffnung des als Fotodiode gestalteten Lichtempfängers eingesetzt. Für die Leuchtdiode kann eine GaAs-Leuchtdiode oder eine GaAlAs-Leuchtdiode gegebenenfalls vom Burrus-Typ verwendet werden. Dagegen kann die Fotodiode beispielsweise eine pin-Diode oder eine Avalanche-Diode oder ein Fototransistor gegebenenfalls in Darlington-Schaltung sein. In zweckmäßiger Weise dient die Öffnung des Lichtempfängers gleichzeitig zur Justierung des Endes der Lichtfaserleitung. Diese Lichtfaserleitung kann in vorteilhafter Weise über eine Immersion mit Kunststoffabdeckung fest an den Lichtsender bzw. den Lichtempfänger angekoppelt werden.

Die Erfindung ermöglicht so eine "Huckepack"-Diodenanordnung für bidirektionalen seriellen Datenaustausch, bei der eine Leuchtdiode als Lichtsender mit einem relativ kleinen Austrittswinkel unter die Fläche einer größeren Fotodiode, in der zur Einführung der Lichtfaserleitung ein Loch vorgesehen ist, so montiert wird, daß der Hauptstrahlkegel des von der Leuchtdiode abgestrahlten Lichtes sich unter dem Loch der Fotodiode befindet. Da der pn-Übergang der Fotodiode sich im Bereich des Loches befindet, wird alles reflektierte Licht, das aus dem Ende der Lichtfaserleitung austritt und von der Leuchtdiode zurückgespiegelt wird, von der Fotodiode empfangen.

Die Steuereinrichtung bewirkt, daß in der Sendephase der Leuchtdiode die Fotodiode auch als Monitor arbeitet, während in der Empfangsphase bei gleichzeitiger Umschaltung der Empfindlichkeit der Fotodiode diese in bereits vorgespanntem Zustand die Empfangsfunktion übernimmt. Durch diese "Vorbelichtung" der Fotodiode im Monitorbetrieb werden besonders hohe Empfindlichkeitswerte erreicht.

Gegebenenfalls kann auch noch die Oberfläche der Leuchtdiode in bestimmten Bereichen verspiegelt werden, um so möglichst das gesamte, aus dem Ende der Lichtfaserleitung austretende Licht zurück zur Fotodiode zu spiegeln.

Nachfolgend wird die Erfindung an Hand der Zeichnung näher erläutert. Es zeigen:

Fig. 1 und 2 herkömmliche optische Sender- und Empfängervorrichtungen,

0120457

Fig. 3        ein erstes Ausführungsbeispiel der Erfin-
              dung,

Fig. 4        ein zweites Ausführungsbeispiel der Erfindung, und

Fig. 5        Signale zur Erläuterung des Betriebs des
              Lichtsenders und des Lichtempfängers in den
              Ausführungsbeispielen der Fig. 3 und 4.

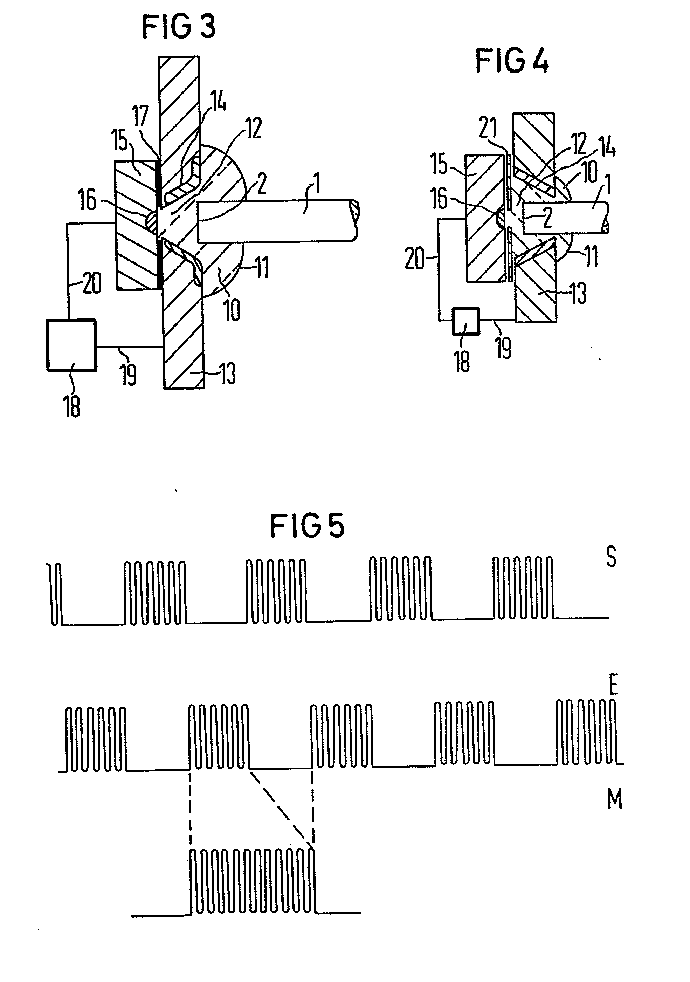

Fig. 3 zeigt ein erstes Ausführungsbeispiel der Erfindung, bei dem eine Lichtleitfaser 1 mit ihrem Ende 2 in
eine Immersion 10 aus lichtdurchlässigem Kunststoff eingebettet ist, die ihrerseits mit einer lichtundurchlässigen Kunststoffabdeckung 11 versehen ist. Die Immersion
10 liegt in einem Loch 12 einer Fotodiode 13, deren
pn-Übergang 14 in der Nähe des Loches 12 verläuft. Am Boden des Loches 12 ist eine Leuchtdiode 15 vorgesehen, deren pn-Übergang 16 im Bereich des Loches 12 der Fotodiode
13 liegt. Die Leuchtdiode 15 und die Fotodiode 13 sind
über eine Klebstoffschicht 17 miteinander fest verbunden.

Weiterhin ist eine Steuereinrichtung 18 vorgesehen, an
die die Fotodiode 13 und die Leuchtdiode 15 angeschlossen
sind, was schematisch durch Leitungen 19, 20 angedeutet
ist. Wenn die Leuchtdiode gerade Licht aussendet, die
Vorrichtung also in einem Sendebetrieb S ist (vgl.
Fig. 5), dann arbeitet die Fotodiode 13 als Monitor,
d. h., sie nimmt einen geringen Teil des von der Leuchtdiode 15 ausgesandten Lichtes auf, um deren Betrieb zu
überwachen. Dieser Monitorbetrieb ist durch M in Fig. 5
angedeutet. Ist dagegen die Vorrichtung auf Empfangsbetrieb E, so ist die Leuchtdiode abgeschaltet und sendet
keine Signale aus. Dagegen hat die Fotodiode 13 ihre
höchste Empfindlichkeit und empfängt das aus dem Ende 2
der Lichtfaserleitung 1 austretende Licht.

0120457

Fig. 4 zeigt ein anderes Ausführungsbeispiel der Erfindung, wobei einander entsprechende Bauteile mit den gleichen Bezugszeichen wie in Fig. 3 versehen sind. Bei diesem Ausführungsbeispiel wird der Durchmesser der Öffnung 12 auf die Leuchtdiode 15 hin größer; außerdem ist noch ein Spiegel 21 vorgesehen, der das aus dem Ende 2 der Lichtfaserleitung 1 austretende Licht zurück zur Fotodiode 13 leitet. Der Betrieb dieser Vorrichtung erfolgt in gleicher Weise, wie dies an Hand der Fig. 3 erläutert wurde.

8 Patentansprüche
5 Figuren

0120457

VPA 83 P 8007 E

Patentansprüche

1. Optische Sender- und Empfängervorrichtung mit einem Lichtsender und einem Lichtempfänger, mit einer an den Lichtsender und den Lichtempfänger fest angekoppelten Lichtfaserleitung zur Übertragung optischer Signale und mit einer Steuereinrichtung, die den Betrieb des Lichtsenders steuert, d a d u r c h  g e k e n n - z e i c h n e t ,  daß der Lichtsender (15) und der Lichtempfänger (13) direkt an das gleiche Ende (2) der Lichtfaserleitung (1) angekoppelt sind und die Steuereinrichtung (18) den Lichtempfänger (13) so steuert, daß dieser wechselseitig mit dem Lichtsender (15) arbeitet und auch als Monitor für den Lichtsender (15) betreibbar ist.

2. Vorrichtung nach Anspruch 1, d a d u r c h  g e - k e n n z e i c h n e t ,  daß der Lichtsender (15) in eine Öffnung (12) des Lichtempfängers (13) eingesetzt ist.

3. Vorrichtung nach Anspruch 1 oder 2, d a d u r c h  g e k e n n z e i c h n e t ,  daß der Lichtsender (15) eine Leuchtdiode ist, und daß der Lichtempfänger (13) eine Fotodiode oder ein Fototransistor ist.

4. Vorrichtung nach Anspruch 3, d a d u r c h  g e - k e n n z e i c h n e t ,  daß die Leuchtdiode eine GaAs-Leuchtdiode oder eine GaAlAs-Leuchtdiode gegebenenfalls vom Burrus-Typ ist.

5. Vorrichtung nach Anspruch 3, d a d u r c h  g e - k e n n z e i c h n e t ,  daß der Lichtempfänger eine pin-Diode oder eine Avalanche-Diode oder ein Fototransistor gegebenenfalls in Darlington-Schaltung ist.

0120457

6. Vorrichtung nach Anspruch 2, d a d u r c h   g e =
k e n n z e i c h n e t ,   daß die Öffnung (12) des
Lichtempfängers (13) zur Justierung der Lichtfaserleitung
(1) dient.

7. Vorrichtung nach Anspruch 2 oder 6,   d a d u r c h
g e k e n n z e i c h n e t ,   daß die Lichtfaserleitung
(1) über eine Immersion (10) mit Kunststoffabdeckung (11)
fest an den Lichtsender (15) bzw. den Lichtempfänger (13)
in der Öffnung (12) des Lichtempfängers (13) angekoppelt
ist.

8. Vorrichtung nach einem der Ansprüche 1 bis 7,   g e -
k e n n z e i c h n e t   durch eine spiegelnde Oberfläche (21) im Bereich des Lichtsenders (15).

FIG 1

FIG 2

## FIG 3

## FIG 4

## FIG 5